# EUROPÄISCHE PATENTSCHRIFT

(11) **EP 0 400 173 B1**
(45) Veröffentlichungstag und Bekanntmachung des Hinweises auf die Patenterteilung: **13.04.1994**
(21) Anmeldenummer: 89109832.9
(22) Anmeldetag: 31.05.1989
(51) Int. Cl.: H01L 21/90

(54) **Verfahren zur Erzeugung wenigstens einer Leiterbahnkreuzung**
Method for manufacturing at least one interconnect crossover
Procédé de fabrication d'au moins un croisement de lignes d'interconnexion

(43) Veröffentlichungstag der Anmeldung: 05.12.1990
(73) Patentinhaber: SIEMENS AKTIENGESELLSCHAFT, 80333 München (DE)
(72) Erfinder: Huber, Jakob, Dipl.-Phys., D-8201 Beyharting (DE)

(56) Entgegenhaltungen:
- GB-A- 1 231 849
- 1985 Proceedings of the 2nd Int. VLSI, Multilevel Interconnection Conference (VMIC) June 25-26, 1985, Santa Clara USA, IEEE, Pages 154-162, A.S. Bergendahl et al.: "A Thick Film Lift-off Technique for High Frequency Interconnection in Wafer Scale Integration"
- IEEE Trans. on Electron devices, Vol ED-27 no 6, June 1980, p 1116-1124, B. Welch et al.: "LSI Processing Technology for Planar GaAs Integrated Circuits."
- IEEE Transactions on Electron Devices, Vol ED-29 no 7, July 1982. p 1094-1102, C. Liechti et al.: "A GaSa MSI Word Generator Operating at 5 Gbits/s Data Rate."

## Beschreibung

Die Erfindung betrifft ein Verfahren zur Erzeugung wenigstens einer Leiterbahnkreuzung.

In der Halbleitertechnologie, insbesondere in der Technologie von Verbindungshalbleitern, insbesondere bei Galliumarsenid, werden weitgehend Abhebe(Lift-off-)Prozesse zur Erzeugung von metallischen Leiterbahnen eingesetzt (S. 1985 Proceedings of the 2nd. Int. VLSI Multilevel Interconnection Conference-VMIC-, Santa Clara USA, IEEE, pages 154-162, A.S. Bergendahl et al.: "A Thick Film Lift-Off Technique for High Frequency Interconnection in Wafer Scale Integration). Um saubere Metall-Kanten zu erhalten, wird auf eine zuverlässige Fotolack-Technik geachtet und wird eine möglichst orthogonale Aufdampf-Geometrie eingestellt. Trotz dieser Maßnahmen treten Metallfransen an den Rändern von Metallisierungen auf.

Häufig werden Leiterbahnkreuzungen, beispielsweise Luftbrücken oder Überkreuzungen mit Doppelisolation, benötigt, beispielsweise für kapazitätsarme Überkreuzungen, beispielsweise für Source-, Gate-oder Drain-Verbindungen, beispielsweise für die Ausführung von Spulen-Mitten, beispielsweise für Kondensator-Überführungen, beispielsweise für Randüberkreuzungen oder für elektrische Anschlüsse (beams) zum Anbonden von Halbleiterbauelementen.

Wird eine zweite Metallisierungs-Ebene, die in Abhebe-Technik strukturiert wird, mit einer Grund-Metallisierungs-Ebene gekreuzt, so besteht an der Leiterbahnkreuzung die Gefahr von Kantenabrissen, bedingt durch die möglichst orthogonale Aufdampfgeometrie der zweiten Metallisierungs-Ebene und bedingt durch möglicherweise unsaubere und zu steile Metallkanten der Grund-Metallisierungs-Ebene.

Der vorliegenden Erfindung liegt die Aufgabe zugrunde, ein verbessertes Verfahren zur Erzeugung wenigstens einer Metallisierungs-Überkreuzung anzugeben.

Diese Aufgabe wird erfindungsgemäß durch ein Verfahren nach dem Patentanspruch 1 gelöst.

Die Erfindung ermöglicht eine Verbesserung von Metallisierungs-Überkreuzungen durch selbstjustiertes Versenken der Grundmetallisierung.

Die Erfindung ermöglicht die Vermeidung von Metallfransen oder von Metallisierungs-Abrissen an Metallisierungs-Überkreuzungen. Die Erfindung ist geeignet für die Erzeugung von Leiterbahnkreuzungen für Kondensator-Überführungen und für sonstige Metallisierungs-Überkreuzungen.

Ausgestaltungen und Vorteile sind im Unteranspruch, der Beschreibung und der Zeichnung angegeben.

Die Erfindung wird im folgenden anhand der Zeichnung näher erläutert.

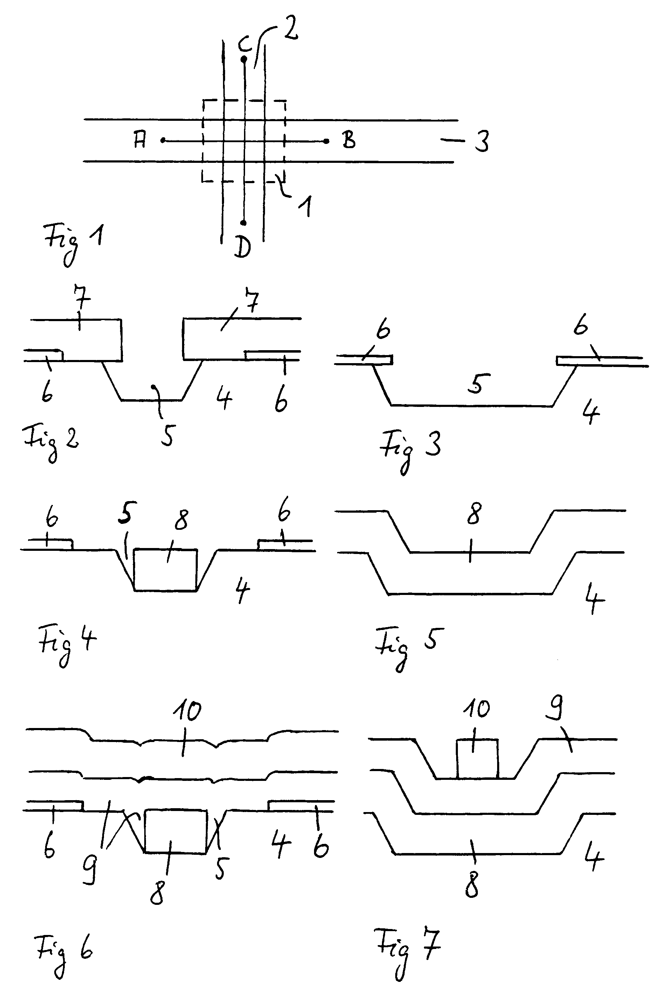

FIG 1 bis 7 erläutern die Erfindung.

Ein Verfahren nach den FIG 1 bis 8 kommt mit sehr wenig zusätzlichem Prozeß-Aufwand aus. Zusätzlich zu bekannten Verfahren zur Herstellung von Metallisierungs-Überkreuzungen wird im einfachsten Fall nur ein Fenster in einem ohnehin verwendeten Grundnitrid und ein zusätzlicher Ätzschritt zum Ätzen eines Substrats unmittelbar vor dem Ätzen des Grundnitrids benötigt.

FIG 1 zeigt in der Draufsicht ein Fenster 1 in einer Hilfsschicht 6, welche auf einem Substrat 4 aufgebracht ist. Als Hilfsschicht 6 kann eine isolierende oder eine metallische Hilfsschicht zwischen einem Halbleitersubstrat 4 und einem Fotolack 7 beim Präparieren des Fotolacks 7 für den Abhebe (Lift-off)-Schritt bei der Erzeugung der Grund-Metallisierungs-Ebene 2 verwendet werden.

Wird bei einem Technologie-Prozeß, beispielsweise bei einem Galliumarsenid-Technologie-Prozeß, auf das Substrat ein Grund-Dielektrikum aufgebracht, so kann dieses Grund-Dielektrikum als Hilfsschicht 6 verwendet werden. Beispielsweise wird als Grund-Dielektrikum in manchen Halbleiter-Technologie-Prozessen ein Grundnitrid mit einer Dicke von 50 nm am Anfang des Technologie-Prozesses auf die Halbleiter-Scheiben (Wafer) aufgebracht.

Als Hilfsschicht 6 kann vor dem Aufbringen des Fotolacks 7 auf die Halbleiterscheibe für die Grundmetallisierungs-Fototechnik eine dünne Metallschicht aufgedampft und mit einem Fenster 1 versehen werden. Als Hilfsschicht 6 kann auch eine Kombination von verschiedenen Schichten dienen.

Als Grundmetallisierung kann die Gate-Metallisierung dienen. Als Grundmetallisierung kann beispielsweise eine etwa 0,6 µm dicke DIOM (Double Implantation-One-Metallization)-Metallisierung dienen. Das DIOM-Verfahren ist beispielsweise in US-A-4 377 030 beschrieben.

Wird als Hilfsschicht 6 eine Nitridschicht verwendet, so können durch diese Nitridschicht hindurch Implantationen erfolgen. Eine Strukturierung der Nitridschicht oder eines anderen Dielektrikums oder einer Metallschicht als Hilfsschicht 6 kann mit Hilfe von Trockenätzen erfolgen.

Das Fenster 1 in der Hilfsschicht 6 umfasst den Bereich der Metallisierungs-Überkreuzung. Das Strukturieren des Fensters 1 kann zugleich mit der Grund-Fototechnik (Erzeugung der Justiermarken) durchgeführt werden.

Nach dem Erzeugen des Fensters 1 in der Hilfsschicht 6 wird Fotolack 7 für die Erzeugung der Grund-Metallisierung in der Grundebene 2 aufgebracht und strukturiert.

Gemäß FIG 2 und 3 wird das Substrat 4 im Bereich 5 bis zu einer geeigneten Tiefe geätzt, wobei die mit dem Fenster 1 versehene Hilfsschicht 6 und der mit der Grund-Metallisierungs-Struktur versehene Fotolack 7 gemeinsam als Ätzmaske dienen.

FIG 2 zeigt ebenso wie die FIG 4 und 6 einen Schnitt durch eine Struktur gemäß FIG 1 entlang den Punkten A und B. FIG 3 zeigt ebenso wie FIG 5 und 7 einen Schnitt der Struktur gemäß FIG 1 entlang den Punkten C und D.

Das Substrat 4 wird im Bereich 5 vorteilhaft anisotrop geätzt, damit unter der Hilfsschicht 6 keine allzu große Unterätzung erfolgt. Anisotropes Ätzen kann sowohl mit Hilfe von reaktivem Ionen-Ätzen als auch mit Hilfe von naß-chemischen Ätzmitteln erfolgen. Wird das Substrat 4 im Bereich 5 nicht anisotrop geätzt, so kann zwischen dem Substrat 4 und der Grundmetallisierung 8 im Bereich der Unterätzung unter der Hilfsschicht 6 ein Loch bleiben, wodurch die Grundmetallisierung 8 geschädigt werden kann.

Das Substrat 4 kann im Bereich 5 beispielsweise bis zu einer Tiefe geätzt werden, die der Metalldicke des Grundmetalls 8 entspricht. Das Substrat 3 kann im Bereich 5 bis zu einer Tiefe geätzt werden, die etwas mehr als der Hälfte der Grundmetallisierung 8 entspricht. Wird beispielsweise eine 0,6 µm dicke Grundmetallisierung 8 verwendet, so kann sie beispielsweise 0,35 µm im Bereich 5 des Substrats 4 eingesenkt sein.

Nach dem Ätzen des Substrats 4 im Bereich 5 wird die Hilfsschicht 6 geätzt, wobei der Fotolack 7 als Ätzmaske dient. Danach wird die Metallisierung des Grundmetalls 8 aufgebracht. Sodann wird der Fotolack abgehoben.

Die gemäß den FIG 4 und 5 sich ergebende Struktur besitzt ein Grundmetall 8, das im Bereich der Metallisierungs-Überkreuzung in das Substrat 4 eingesenkt ist. Bei einer Struktur nach den FIG 4 und 5 kann die Hilfsschicht 6 entfernt werden, falls dies erforderlich ist.

Gemäß den FIG 6 und 7 kann auf das Grundmetall 8 ein Dielektrikum (Passivierung) 9 aufgebracht werden. Auf dieses Dielektrikum 9 kann erneut Fotolack aufgebracht werden, der erneut strukturiert wird zur Erzeugung der Metallisierungsstrukturen der zweiten Metallisierungsebene 3. Nach Aufbringen der zweiten Metallisierung 10 kann auch der zweite Fotolack abgehoben werden, so daß sich eine Struktur gemäß den FIG 6 und 7 im Bereich der Metallisierungs-Überkreuzung gemäß FIG 1 ergibt.

Die zweite Metallisierung 10 kann auch in einem Atzverfahren strukturiert werden.

Aufgrund der Ätzung des Substrats 4 im Bereich 5 entstehen an der Kreuzungsstelle keine "Kantenwürmer". Wegen der geringeren Stufenhöhe an der Kreuzungsstelle verringert sich die Gefahr, daß die zweite Metallisierung 10 an der Stufe im Bereich der Kreuzungsstelle reißt.

Die Erfindung eignet sich für alle Halbleiter-Bauelemente, bei denen Metallisierungen sich kreuzen. Die Erfindung eignet sich für komplexe Halbleiterbauelemente, beispielsweise für Speicher, integrierte Schaltungen usw. Die Erfindung eignet sich auch für Silizium-Bauelemente.

Die Ätzung 5 muß nicht notwendig in einem Halbleitersubstrat erfolgen. Unter der Hilfsschicht 6 kann auch anderes Material liegen, beispielsweise eine andere Schicht aus einem anderen Material, in der eine Atzung in einem Bereich 5 vorgenommen wird. In diesem Bereich 5 wird dann in jedem Fall die Grund-Metallisierung 8 eingesenkt.

## Patentansprüche

1. Verfahren zur Erzeugung wenigstens einer Metallisierungs-Überkreuzung auf einem Halbleiter-Bauelement, bei dem
a) eine Hilfsschicht (6) im Bereich der Metallisierungs-Überkreuzung mit einem Fenster (1) versehen wird,
b) ein Fotolack (7) aufgebracht wird und für die Grundmetallisierung (8) der Grundebene (2) strukturiert wird,
c) der unter der Hilfsschicht (6) bzw. unter dem Fotolack (7) liegende Bereich (5) des Substrats (4) geätzt wird unter Verwendung der mit dem Fenster (1) versehenen Hilfsschicht (6) und dem für die Grundmetallisierung (8) der Grundebene (2) strukturierten Fotolack (7) als gemeinsamer Ätzmaske bis zu einer Tiefe, die das Versenken der Grundmetallisierung (8) in diesen geätzten Bereich (5) unter der Hilfsschicht (6) ermöglicht,
d) die Hilfsschicht (6) geätzt wird unter Verwendung des für die Grundmetallisierung (8) der Grundebene (2) strukturierten Fotolacks (7) als Ätzmaske,
e) die Grundmetallisierung (8) aufgebracht wird,
f) der Fotolack (7) abgehoben wird,
g) ein Dielektrikum (9) auf die Grundmetallisierung (8) aufgebracht wird, und
h) eine zweite Metallebene (10) im Bereich der Metallisierungs-Überkreuzung aufgebracht wird.

2. Verfahren nach Anspruch 1,
**dadurch gekennzeichnet,** daß der unter der Hilfsschicht (6) bzw. unter dem Fotolack (7) liegende Bereich (5) anisotrop geätzt wird.

## Claims

1. Method of producing at least one metallization crossover on a semiconductor component, in which
a) an auxiliary layer (6) is provided with a window (1) in the region of the metallization crossover,
b) a photoresist (7) is applied and patterned for the base metallization (8) of the base level (2),
c) that region (5) of the substrate (4) which is situated underneath the auxiliary layer (6) or underneath the photoresist (7) is etched using the auxiliary layer (6), provided with the window (1), and the photoresist (7), patterned for the base metallization (8) of the base level (2), as common etching mask to a depth which makes it possible to recess the base metallization (8) in the said etched region (5) underneath the auxiliary layer (6),
d) the auxiliary layer (6) is etched using the photoresist (7) patterned for the base metallization (8) of the base level (2) as etching mask,
e) the base metallization (8) is applied,
f) the photoresist (7) is lifted off,
g) a dielectric (9) is applied to the base metallization (8), and
h) a second metal level (10) is applied in the region of the metallization crossover.

2. Method according to Claim 1, characterized in that the region (5) underneath the auxiliary layer (6) or underneath the photoresist (7) is etched anisotropically.

## Revendications

1. Procédé de fabrication d'au moins un croisement de la métallisation sur un module à semiconducteurs, dans lequel :
a) une couche auxiliaire (6) est munie d'une fenêtre (1), dans la zone du croisement de la métallisation,
b) un vernis photosensible (7) est déposé, et est structuré pour la métallisation de base (8) du plan de base (2),
c) la zone (5) du substrat (4) se trouvant en-dessous de la couche auxiliaire (6) ou en-dessous du vernis photosensible (7) est gravé avec utilisation de la couche auxiliaire (6) munie de la fenêtre (1) et du vernis photosensible (7), structuré pour la métallisation de base (8) du plan de base (2), en tant que masque de gravure commun jusqu'à une profondeur qui permet d'enfoncer la métallisation de base (8) dans cette zone gravée (5) en-dessous de la couche auxiliaire (6).
d) la couche auxiliaire (6) est gravée moyennant l'utilisation du vernis photosensible (7), structuré pour la métallisation de base (8) du plan de base (2), en tant que masque de gravure,
e) la métallisation de base (8) est déposée,
f) le vernis photosensible (7) est détaché,
j) un diélectrique (9) est déposé sur la métallisation de base (8), et
h) un deuxième plan de métallisation (10) est déposé dans la zone du croisement de la métallisation.

2. Procédé suivant la revendication 1, caractérisé en ce que la zone (5) présente en-dessous de la couche auxiliaire (6) ou en-dessous du vernis photosensible (7) est gravée de manière anisotrope.
